# FASCICULE DE BREVET EUROPEEN

(11) **EP 3 299 827 B1**
(45) Date de publication et mention de la délivrance du brevet: **02.12.2020**
(21) Numéro de dépôt: 17192582.9
(22) Date de dépôt: 22.09.2017
(51) Int. Cl.: G01R 31/52, H02H 3/44

(54) **PROCÉDÉ DE DÉTECTION D'UN COURT-CIRCUIT DANS UN CIRCUIT ÉLECTRIQUE COMPRENANT UN TRANSISTOR DU TYPE IGBT ET DISPOSITIF DE PILOTAGE ASSOCIÉ**
DETEKTIONSVERFAHREN EINES KURZSCHLUSSES IN EINEM ELEKTRISCHEN SCHALTKREIS, DER EINEN IGBT-TRANSISTOR UMFASST, UND ENTSPRECHENDE STEUERUNGSVORRICHTUNG
METHOD OF DETECTION OF A SHORT CIRCUIT IN AN ELECTRICAL NETWORK COMPRISING A TRANSISTOR OF IGBT TYPE AND ASSOCIATED CONTROLLING DEVICE

(30) Priorité: 23.09.2016 FR 1658983
(43) Date de publication de la demande: 28.03.2018
(73) Titulaire: ALSTOM Transport Technologies, 93400 Saint-Ouen (FR)
(72) Inventeur: ANDRIANOELISON, Florent, 65800 Aureilhan (FR); RABASSE, Eric, 65310 Horgues (FR); BOISTEAU, Stephane, 86280 Saint Benoit (FR)
(74) Mandataire: Lavoix

(56) Documents cités:
- FR-A1- 3 013 919
- US-A1- 2004 240 240
- US-A1- 2007 119 406
- US-A1- 2012 182 031
- MAHMOUD SHAHBAZI ET AL: "Open- and Short-Circuit Switch Fault Diagnosis for Nonisolated DC DC Converters Using Field Programmable Gate Array", IEEE TRANSACTIONS ON INDUSTRIAL ELECTRONICS, IEEE SERVICE CENTER, PISCATAWAY, NJ, USA, vol. 60, no. 9, 1 septembre 2013 (2013-09-01), pages 4136-4146, XP011507081, ISSN: 0278-0046, DOI: 10.1109/TIE.2012.2224078

## Description

La présente invention concerne un procédé de détection d'un court-circuit dans un circuit électrique comprenant un transistor du type IGBT et un dispositif de pilotage associé.

De manière connue en soi, un transistor du type IGBT (de l'anglais « *Insulated Gate Bipolar Transistor* ») appelé également transistor bipolaire à grille isolée, comprend trois bornes ou contacts électriques, à savoir une grille, un collecteur et un émetteur.

Un transistor du type IGBT est particulièrement utilisable comme interrupteur électrique. En effet, un tel transistor définit un état passant dans lequel le collecteur est connecté électriquement à l'émetteur et un état bloqué dans lequel ils sont isolés électriquement l'un de l'autre.

La commutation entre les deux états est pilotée par une tension de consigne appliquée sur la grille par des moyens de commande adaptés.

En particulier, la commutation entre l'état bloqué et l'état passant comprend une phase de commutation à l'amorçage consistant à commuter le transistor de l'état bloqué vers l'état passant, et une phase de commutation au blocage consistant à commuter le transistor de l'état passant vers l'état bloqué.

Généralement, le fonctionnement d'un transistor du type IGBT est contrôlé par un dispositif de pilotage adapté permettant notamment de détecter un court-circuit au sein du circuit électrique dans lequel le transistor est utilisé.

Un tel court-circuit est susceptible d'apparaitre par exemple entre le collecteur et l'émetteur d'un transistor IGBT complémentaire dans un bras lors de phase de commutation à l'amorçage du transistor concerné et peut endommager sérieusement ce dernier.

Pour détecter un court-circuit, les dispositifs de pilotage existants mettent en œuvre un procédé de détection comprenant l'analyse des mesures de la tension entre le collecteur et l'émetteur et la détection d'un court-circuit en fonction de ces mesures.

On connait également des méthodes de détection d'un court-circuit dans les transistors IGBT, telles que décrites dans les documents US 2012/182031 A1, US 2004/240240 A1 ou dans l'article "Open- and Short-Circuit Switch Fault Diagnosis for Nonisolated DC DC Converters Using Field Programmable Gate Array", M. Shahbazi et al, IEEE Transactions on Industrial Electronics, vol. 60, no. 9, pp. 4136-4146, September 2013.

Toutefois, les dispositifs de pilotage existants ainsi que les procédés de détection d'un court-circuit mis en œuvre par ces dispositifs, ne sont pas complètement satisfaisants.

En particulier, une grande précision dans les mesures de la tension est généralement nécessaire pour détecter efficacement un court-circuit. Ce problème dévient particulièrement pertinent pour des transistors fonctionnant sous la haute tension comme par exemple ceux utilisés dans le domaine ferroviaire.

La présente invention a pour but de proposer un procédé de détection d'un court-circuit dans un circuit électrique comprenant un transistor du type IGBT permettant de détecter efficacement un court-circuit sans que des mesures précises de la tension dans le transistor soient nécessaires.

À cet effet, l'invention a pour objet un procédé de détection conforme à la revendication 1.

Suivant d'autres aspects avantageux de l'invention, le procédé comprend une ou plusieurs des caractéristiques des revendications 2 à 4.

L'invention a également pour objet un dispositif de pilotage conforme à la revendication 5.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une vue schématique d'un circuit électrique intégrant notamment un transistor du type IGBT et un dispositif de pilotage de ce transistor selon l'invention ;
- la figue 2 est un organigramme d'un procédé de détection d'un court-circuit mis en œuvre par le dispositif de pilotage de la figure 1 ; et
- la figure 3 est une vue schématique illustrant le procédé de détection d'un court-circuit de la figure 2.

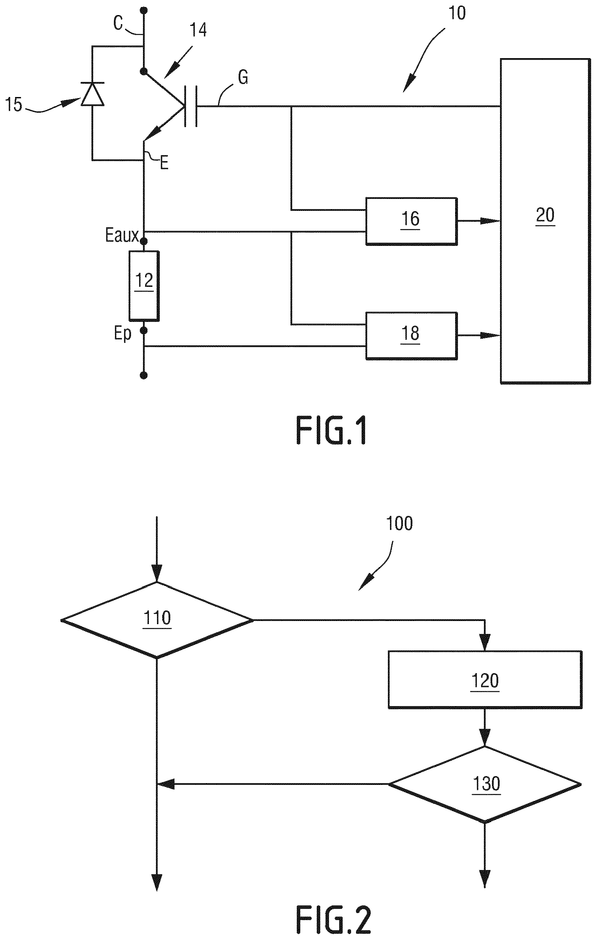

Le circuit électrique 10 de la figure 1 est utilisable pour commander au moins en partie le fonctionnement d'un composant de puissance 12 comportant notamment deux bornes Eₐᵤₓ et Eₚ.

Le circuit électrique 10 et le composant de puissance 12 sont notamment utilisables dans le domaine ferroviaire et sont, par exemple, embarqués dans un véhicule ferroviaire.

En référence à la figure 1, le circuit électrique 10 comprend un transistor 14 connecté au composant de puissance 12 et un dispositif de pilotage 20 du transistor 14 selon l'invention.

Le transistor 14 est un transistor du type IGBT (de l'anglais « *Insulated Gate Bipolar Transistor* ») appelé également transistor bipolaire à grille isolée.

Le transistor 14 est connu en soi et comporte en particulier trois bornes ou contacts électriques, à savoir, une grille G, un collecteur C et un émetteur E.

L'émetteur E est connecté notamment à la borne Eₐᵤₓ du composant de puissance 12.

Le transistor 14 définit un état passant dans lequel un courant électrique I_{C}, appelé par la suite courant principal, s'écoule entre le collecteur C et l'émetteur E et un état bloqué dans lequel le collecteur C est isolé électriquement de l'émetteur E.

Par ailleurs, la diode 15 permet le passage d'un courant électrique de l'émetteur E vers le collecteur C quel que soit l'état du transistor 14.

Le module de mesure de tension 16 est connecté d'une part à la grille G et de l'autre part à l'émetteur E du transistor 14 et permet de mesurer une tension V_{GE} entre la grille G et l'émetteur E.

Le module de mesure de tension 16 présente par exemple un voltmètre de type adapté.

Le module de mesure de changement de courant 18 est connecté aux bornes Eₐᵤₓ et Eₚ du composant de puissance 12 et permet de détecter tout changement de l'intensité du courant principal I_{C} passant par le composant électrique 12.

Autrement dit, le module 18 permet de détecter toute croissance ou toute décroissance de valeurs d'intensité du courant principal I_{C} dans le temps.

Encore autrement dit, le module 18 permet de détecter le signe de la dérivée temporelle dI_{C}/dt du courant principal I_{C}.

Pour ce faire, le module 18 est apte à mesurer la tension U entre les bornes Eₐᵤₓ et Eₚ du composant de puissance 12. Le signe de la dérivée temporelle dI_{C}/dt du courant principal I_{C} est déterminé par le signe de la tension U car la dérivée temporelle dI_{C}/dt et la tension U sont linéairement dépendantes. En effet, la tension U est égale au produit de la dérivée temporelle dI_{C}/dt et de l'inductance du composant de puissance 12.

Le dispositif de pilotage 20 est connecté à la grille G du transistor 14 et apte à piloter le fonctionnement de ce transistor 14 en appliquant une tension de consigne et un courant de consigne sur la grille G.

Le dispositif de pilotage 20 est apte en outre à mettre en œuvre un procédé de détection d'un court-circuit 100 décrit plus en détail par la suite.

Le dispositif de pilotage 20 est connecté en outre aux modules 16 et 18 pour récupérer des mesures respectivement de la tension V_{GE} et du signe de dI_{C}/dt et à une source d'alimentation (non-illustré) fournissant une tension de consigne positive et une tension de consigne négative.

La tension de consigne positive est par exemple sensiblement égale à +15 V.

La tension de consigne négative est par exemple sensiblement égale à -15 V.

Le dispositif de pilotage 20 comprend par exemple un circuit de commande et un calculateur connecté au circuit de commande et permettant de traiter numériquement des mesures issues des modules 16 et 18 pour mettre en œuvre au moins certaines étapes du procédé de détection 100.

Finalement, le dispositif de pilotage 20 est apte à recevoir un ordre d'amorçage et un ordre de blocage du transistor 14 issus par exemple d'un calculateur central (non-illustré).

Le fonctionnement du circuit électrique 10 et en particulier du transistor 14, sera désormais expliqué.

Le pilotage du fonctionnement du transistor 14 mis en œuvre par le dispositif de pilotage 20 comprend une phase de commutation à l'amorçage, une phase d'amorçage, une phase de commutation au blocage et une phase de blocage.

Lors de la phase d'amorçage, le dispositif de pilotage 20 maintient le transistor 14 dans l'état passant en appliquant la tension de consigne positive sur la grille G.

Lors de la phase de blocage, le dispositif de pilotage 20 maintient le transistor 14 dans l'état bloqué en appliquant la tension de consigne négative sur la grille G.

La phase de commutation à l'amorçage est une phase transitoire entre la phase de blocage et la phase d'amorçage et permet notamment de faire passer le transistor 14 de l'état bloqué à l'état passant.

La phase de commutation au blocage est une phase transitoire entre la phase d'amorçage et la phase de blocage et permet notamment de faire passer le transistor 14 de l'état passant à l'état bloqué.

Les phases de commutation à l'amorçage et au blocage comprennent plusieurs étapes de commutation. Lors de ces étapes, le dispositif de pilotage 20 génère un courant de consigne dont l'intensité sur la grille du transistor 14 prend des valeurs de consigne différentes en fonction de l'étape de commutation en cours.

Selon un exemple de réalisation, les moments de transition entre les étapes de commutation sont déterminés en fonction du signe de la dérivée temporelle dI_{C}/dt du courant principal I_{C}, des mesures de la tension V_{GE} entre la grille G et l'émetteur, et/ou de la durée maximale acceptable des étapes correspondantes.

Selon un autre exemple de réalisation, ces moments de transition sont déterminés en fonction des mesures de la tension entre le collecteur et l'émetteur, et de l'intensité du courant électrique passant via le collecteur.

Lors de la phase de commutation à l'amorçage, le dispositif de pilotage 20 met en œuvre le procédé de commutation de détection 100 d'un court-circuit.

En particulier, ce procédé 100 comprend plusieurs étapes dont l'organigramme est illustré sur la figure 2.

Lors d'une étape 110, le dispositif de pilotage 20 observe le signe de la dérivée temporelle dI_{C}/dt du courant principal I_{C} dans une fenêtre temporelle d'observation T_{obs}.

Le début de la fenêtre temporelle d'observation T_{obs} correspond au début de la phase de commutation à l'amorçage.

Si la dérivée temporelle dI_{C}/dt du courant principal I_{C} est strictement positive lors d'une période de test Tₜ prédéterminée, le dispositif 20 détecte la présence d'un court-circuit lors d'une étape 120. Dans le cas contraire, le dispositif de pilotage 20 déduit qu'un court-circuit ne peut pas avoir lieu.

Avantageusement, le procédé comprend en outre une étape 130 lors de laquelle le dispositif 20 confirme la présence du court-circuit détecté.

En particulier, lors de cette étape 130, le dispositif de pilotage 20 confirme la présence du court-circuit lorsque la dérivée temporelle dlc/dt du courant principal Ic reste supérieure ou égale à zéro pendant une période complémentaire suivant la période de test Tₜ. Dans le cas contraire, le dispositif de pilotage 20 déduit que le court-circuit n'a pas eu lieu.

La période complémentaire débute à la fin de la période de test Tₜ et se termine par exemple avec la fenêtre temporelle d'observation T_{obs}.

Lorsqu'un court-circuit a été détecté, le dispositif de pilotage 20 signale alors un court-circuit et maintien le transistor 14 dans l'état bloqué au moins pendant une période de blocage prédéterminé.

La période de test Tₜ est paramétrable par le dispositif de pilotage 20 et réglable préalablement à la mise en œuvre du précédé 100 par exemple entre 1 µs et 10 µs.

La longueur de la fenêtre d'observation T_{obs} est paramétrable par le dispositif de pilotage 20 et réglable préalablement à la mise en œuvre du précédé 100 par exemple entre 1 µs et 20 µs.

La période de test Tₜ et la période complémentaire sont comprises dans la fenêtre d'observation T_{obs}.

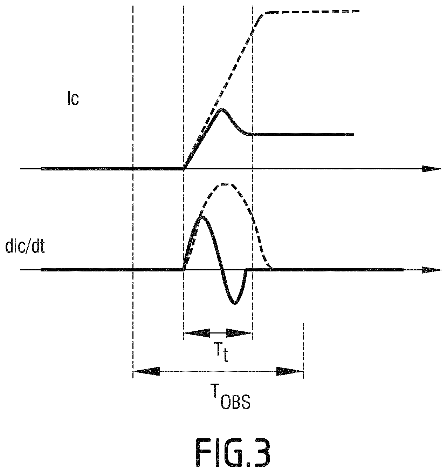

La figure 3 illustre le comportement du courant principal I_{C} et de la dérivée temporelle dI_{C}/dt du courant principal I_{C} dans deux exemples de la mise en œuvre de la phase de commutation à l'amorçage.

Dans le premier exemple correspondant aux traits continus des courbes I_{C} et dI_{C}/dt, aucun court-circuit ne s'est produit. Dans ce cas, la dérivée dI_{C}/dt a changé de signe lors de la période de test Tₜ et le dispositif de pilotage 20 n'a donc détecté aucun court-circuit.

Dans le deuxième exemple correspondant aux traits interrompus des courbes I_{C} et dI_{C}/dt, un court-circuit a apparu. Dans ce cas, la dérivée dI_{C}/dt a été strictement positive lors de la période de test Tₜ et positive en dehors de cette période. Le dispositif de pilotage 20 a donc détecté un court-circuit.

On conçoit alors que la présente invention présente un certain nombre d'avantages.

Le procédé de détection selon l'invention permet de détecter un court-circuit dans le transistor en utilisant uniquement l'analyse du signe de la dérivée dI_{C}/dt du courant principal I_{C} dans différentes périodes temporelles.

Il est à noter qu'aucune mesure de la valeur du courant principal I_{C} ni celle de sa dérivée dI_{C}/dt n'est nécessaire pour mettre en œuvre le procédé. Ainsi, seul le signe de la dérivée dI_{C}/dt est important pour le procédé de détection ce qui permet de simplifier les exigences imposées à des différents moyens de mesure dans le circuit électrique.

Ceci est particulièrement avantageux pour les transistors fonctionnant sous la haute tension notamment comme ceux utilisés dans le domaine ferroviaire.

Finalement, il est à noter que pour détecter un court-circuit, aucun circuit de contre-réaction et en particulier, aucun circuit lié à la tension aux bornes du composant de puissance n'est nécessaire pour limiter la surtension au blocage. Ceci constitue alors un avantage particulier de l'invention.

## Revendications

1. Procédé (100) de détection d'un court-circuit dans un circuit électrique (10) comprenant un transistor (14) du type IGBT, le transistor (14) comportant une grille (G), un collecteur (C) et un émetteur (E), et définissant un état passant dans lequel un courant principal (I_{C}) s'écoule entre le collecteur (C) et l'émetteur (E) et un état bloqué dans lequel le collecteur (C) est isolé électriquement de l'émetteur (E) ;
le procédé de détection (100) comprend l'observation du signe de la dérivée temporelle (dI_{C}/dt) du courant principal (I_{C}) dans une fenêtre temporelle d'observation (T_{obs}) de longueur prédéterminée et la détection d'un court-circuit dans cette fenêtre temporelle d'observation (T_{obs}) en fonction du signe de la dérivée temporelle (dI_{C}/dt) du courant principal (I_{C}) ;
le procédé de détection comprenant les étapes suivantes :
- observer (110) le signe de la dérivée temporelle (dI_{C}/dt) du courant principal (I_{C}) dans la fenêtre temporelle d'observation (Tobs) ; le début de la fenêtre temporelle d'observation (Tobs) correspondant au début d'une phase de commutation à l'amorçage, consistant à commuter le transistor (14) de l'état bloqué vers l'état passant ;
- lorsque la dérivée temporelle (dIc/dt) du courant principal (Ic) reste strictement positive pendant une période de test (Tₜ) prédéterminée, détecter (120) la présence d'un court-circuit.

2. Procédé selon la revendication 1, comprenant en outre une étape (130) de confirmation de la présence d'un court-circuit consistant à confirmer la présence d'un court-circuit lorsque la dérivée temporelle (dlc/dt) du courant principal (Ic) reste supérieure ou égale à zéro pendant une période complémentaire suivant la période de test (Tₜ).

3. -Procédé (100) selon l'une quelconque des revendications précédentes, comprenant en outre le maintien du transistor (14) dans l'état bloqué en cas de détection d'un court-circuit.

4. -Procédé (100) selon l'une quelconque des revendications précédentes, dans lequel la longueur de la fenêtre d'observation (T_{obs}) est comprise entre 1 µs et 20 µs.

5. -Dispositif de pilotage (20) d'un transistor (14) du type IGBT, le transistor (14) comportant une grille (G), un collecteur (C) et un émetteur (E), et définissant un état passant dans lequel un courant principal (I_{C}) s'écoule entre le collecteur (C) et l'émetteur (E) et un état bloqué dans lequel le collecteur (C) est isolé électriquement de l'émetteur (E) ;
le dispositif (20) étant configuré pour observer le signe de la dérivée temporelle (dI_{C}/dt) du courant principal (I_{C}) dans une fenêtre temporelle d'observation (T_{obs}) de longueur prédéterminée et à détecter un court-circuit dans cette fenêtre temporelle d'observation (T_{obs}) en fonction du signe de la dérivée temporelle (dI_{C}/dt) du courant principal (I_{C}) ;
- observer le signe de la dérivée temporelle (dI_{C}/dt) du courant principal (I_{C}) dans la fenêtre temporelle d'observation (Tobs) ; le début de la fenêtre temporelle d'observation (Tobs) correspondant au début d'une phase de commutation à l'amorçage, consistant à commuter le transistor (14) de l'état bloqué vers l'état passant ;
- lorsque la dérivée temporelle (dlc/dt) du courant principal (Ic) reste strictement positive pendant une période de test (Tₜ) prédéterminée, détecter la présence d'un court-circuit.

## Patentansprüche

1. Verfahren (100) zum Detektieren eines Kurzschlusses in einem elektrischen Schaltkreis (10), welcher einen Transistor (14) vom IGBT-Typ aufweist, wobei der Transistor (14) ein Gate (G), einen Kollektor (C) und einen Emitter (E) aufweist und einen Durchlass-Zustand, in welchem ein Hauptstrom (I_{C}) zwischen dem Kollektor (C) und dem Emitter (E) fließt, und einen Blockier-Zustand, in welchem der Kollektor (C) vom Emitter (E) elektrisch isoliert ist, definiert,
wobei das Verfahren zum Detektieren (100) aufweist das Beobachten des Vorzeichens der zeitlichen Ableitung (dI_{C}/dt) des Hauptstroms (I_{C}) in einem zeitlichen Beobachtungsfenster (T_{obs}) mit vorbestimmter Länge und das Detektieren eines Kurzschlusses in diesem zeitlichen Beobachtungsfenster (T_{obs}) in Abhängigkeit vom Vorzeichen der zeitlichen Ableitung (dlc/dt) des Hauptstroms (I_{C}),
wobei das Verfahren zum Detektieren die folgenden Schritte aufweist
- Beobachten (110) des Vorzeichens der zeitlichen Ableitung (dI_{C}/dt) des Hauptstroms (I_{C}) in einem zeitlichen Beobachtungsfenster (T_{obs}), wobei der Anfang des zeitlichen Beobachtungsfensters (T_{obs}) zum Anfang einer Einschalt-Schaltphase korrespondiert, welche aus dem Schalten des Transistors (14) vom Blockier-Zustand in den Durchlass-Zustand besteht,
- wenn die zeitliche Ableitung (dI_{C}/dt) des Hauptstroms (I_{C}) während einer vorbestimmten Testdauer (Tₜ) strikt positiv bleibt, Detektieren (120) des Vorhandenseins eines Kurzschlusses.

2. Verfahren gemäß Anspruch 1, welches ferner einen Schritt (130) des Bestätigens des Vorhandenseins eines Kurzschlusses aufweist, welcher besteht aus dem Bestätigen des Vorhandenseins eines Kurzschlusses, wenn die zeitliche Ableitung (dI_{C}/dt) des Hauptstroms (I_{C}) während einer Komplementärdauer, welche auf die Testdauer (Tₜ) folgt, größer oder gleich null bleibt.

3. Verfahren (100) gemäß irgendeinem der vorherigen Ansprüche, welches ferner das Beibehalten des Transistors (14) in dem Blockier-Zustand im Fall des Detektierens eines Kurzschlusses aufweist.

4. Verfahren (100) gemäß irgendeinem der vorherigen Ansprüche, wobei die Länge des Beobachtungsfensters (T_{obs}) zwischen 1 µs und 20 µs liegt.

5. Vorrichtung zum Steuern (20) eines Transistors (14) vom IGBT-Typ, wobei der Transistor (14) ein Gate (G), einen Kollektor (C) und einen Emitter (E) aufweist und einen Durchlass-Zustand, in welchem ein Hauptstrom (I_{C}) zwischen dem Kollektor (C) und dem Emitter (E) fließt, und einen Blockier-Zustand, in welchem der Kollektor (C) vom Emitter (E) elektrisch isoliert ist, definiert,
wobei die Vorrichtung (20) eingerichtet ist, um
das Vorzeichen der zeitlichen Ableitung (dI_{C}/dt) des Hauptstroms (I_{C}) in einem zeitlichen Beobachtungsfenster (T_{obs}) mit vorbestimmter Länge zu beobachten, und um einen Kurzschluss in diesem zeitlichen Beobachtungsfenster (T_{obs}) in Abhängigkeit vom Vorzeichen der zeitlichen Ableitung (dI_{C}/dt) des Hauptstroms (I_{C}) zu detektieren,
- das Vorzeichen der zeitlichen Ableitung (dI_{C}/dt) des Hauptstroms (I_{C}) in dem zeitlichen Beobachtungsfenster (T_{obs}) zu beobachten, wobei der Anfang des zeitlichen Beobachtungsfensters (Tobs) zum Anfang einer Einschalt-Schaltphase korrespondiert, welche aus dem Schalten des Transistors (14) vom Blockier-Zustand in den Durchlass-Zustand besteht,
- wenn die zeitliche Ableitung (dlc/dt) des Hauptstroms (Ic) während einer vorbestimmten Testdauer (Tₜ) strikt positiv bleibt, das Vorhandensein eines Kurzschlusses zu detektieren.

## Claims

1. A method (100) for detecting a short-circuit in an electrical network (10) comprising a transistor (14) of the IGBT type, the transistor (14) comprising a gate (G), a collector (C) and an emitter (E), and defining an on state in which a main current flows (I_{C}) between the collector (C) and the emitter (E) and an off state in which the collector (C) is electrically isolated from the emitter (E);
the detection method (100) comprises observing the sign of the temporal derivative (dI_{C}/dt) of the main current (I_{C}) in a temporal observation window (T_{obs}) with a predetermined length and detecting a short-circuit in this temporal observation window (T_{obs}) based on the sign of the temporal derivative (dI_{C}/dt) of the main current (I_{C});
the method comprising the following steps:
- observing (110) the sign of the temporal derivative (dI_{C}/dt) of the main current (I_{C}) in the temporal observation window (T_{obs}), the beginning of the temporal observation window (T_{obs}) corresponding to the beginning of a phase for switching to firing consisting of switching the transistor (14) from the off state to the on state;
- when the temporal derivative (dI_{C}/dt) of the main current (Ic) is strictly positive during a predetermined test period (Tₜ), detecting (120) the presence of a short-circuit.

2. The method (100) according to claim 1, further comprising a step (130) for confirming the presence of a short-circuit consisting of confirming the presence of a short-circuit when the temporal derivative (dI_{C}/dt) of the main current (I_{c}) remains greater than or equal to zero for an additional period according to the test period (Tₜ).

3. The method (100) according to any one of the preceding claims, further comprising keeping the transistor (14) in the off state if a short-circuit is detected.

4. The method (100) according to any one of the preceding claims, wherein the length of the observation window (T_{obs}) is comprised between 1 µs and 20 µs.

5. A control device (20) for a transistor (14) of the IGBT type, the transistor (14) comprising a gate (G), a collector (C) and an emitter (E), and defining an on state in which a main current flows (I_{C}) between the collector (C) and the emitter (E) and an off state in which the collector (C) is electrically isolated from the emitter (E);
the device (20) being configured to:
- observe the sign of the temporal derivative (dI_{C}/dt) of the main current (I_{C}) in a temporal observation window (T_{obs}) with a predetermined length and detect a short-circuit in this temporal observation window (T_{obs}) based on the sign of the temporal derivative (dI_{C}/dt) of the main current (I_{C});
- observe the sign of the temporal derivative (dI_{C}/dt) of the main current (I_{C}) in the temporal observation window (T_{obs}), the beginning of the temporal observation window (T_{obs}) corresponding to the beginning of a phase for switching to firing consisting of switching the transistor (14) from the off state to the on state;
- when the temporal derivative (dI_{C}/dt) of the main current (Ic) is strictly positive during a predetermined test period (Tₜ), detect the presence of a short-circuit.
